# EUROPEAN PATENT APPLICATION

(11) **EP 1 696 496 A1**
(43) Date of publication of application: **30.08.2006**
(21) Application number: 05008142.1
(22) Date of filing: 14.04.2005
(51) Int. Cl.: H01L 33/00, H01L 27/15

(54) **Light emitting device**

(30) Priority: 25.02.2005 CN 200510008960
(71) Applicant: SuperNova Optoelectronics Corporation, Pingjhen City Taoyuan County 324 (TW)
(72) Inventor: Mu-Jen, Lai, Jhongshan District, Taipei Taiwan (TW)
(74) Representative: Manasse, Uwe

(57) **Abstract**

This invention discloses a light emitting device that uses a light emitting diode (LED) to simultaneously emit two light sources of different wavelengths in combination with selected specific fluorescent materials to absorb one of the foregoing two lights source of different wavelengths and then generate a third light source of another different wavelength to form a white light spectrum by combining with the two different wavelengths of the light sources of the LED.

## Description

### FIELD OF THE INVENTION

The present invention generally relates to light emitting devices, and more specifically relates to a white light emitting device having high color rendering and wide spectrum that adopts a light device including at least two light emitting layers mixed with at least one phosphor.

### BACKGROUND OF THE INVENTION

Light emitting diode (LED) is a solid semiconductor device, which produces a light source by combining two separate carriers (a negative charged electron and a positive charged via hole) and is belong to cold light emissions. Unlike hot light emitting tungsten light bulbs, an LED can emit light by simply passing a very small current through both ends of the LED component. Since different materials are used for making LEDs, the energy levels of the electrons and via holes in the LEDs are different. The difference of energy levels affects the energy of the combined photons to produce lights of different wavelengths which are different colored lights such as red, orange, yellow, green, blue, or invisible lights. The spectrum of a white light generally includes the spectra of the three primary color wavelengths of the red, green and blue colors. The light emitting diode has the advantages of long-life, power-saving, durable, vibration-resisting, secure and reliable, applicable for mass production, small size and quick response.

Light emitting diodes are mainly used for the backlight and press button of mobile phones, the backlight of personal digital assistant (PDA), the indicating lights of information and consumer electronic products, industrial meters and equipments, automobile meter indicating lights and brake lights, large advertising billboards and traffic signals, etc.

The present white LED applications include the lighting for an automobile reading lamp, a decorative lamp, and the like, but over 95% of the white LEDs are used for the backlight of LCDs. With the limitations of the light emitting efficiency and lifetime of a white LED, the white LED is mainly used for small size backlight, and the white emitting light diode comprised of a high-brightness blue light emitting diode and a fluorescent powder (YAG:Ce) is considered as a new-generation power-saving light source. In addition, the white LED made of an ultraviolet (UV) light emitting diode and three-wavelength fluorescent materials also becomes a new-generation light source.

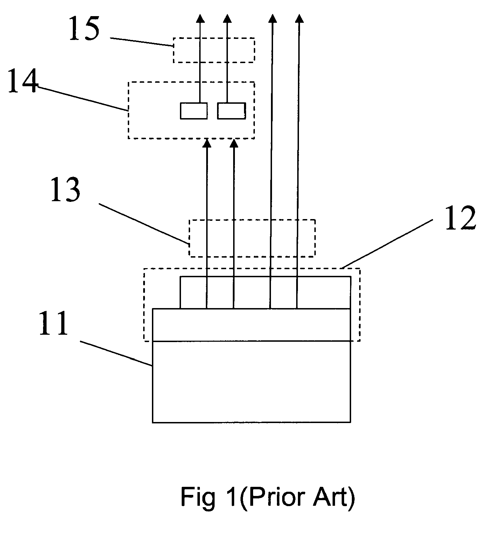

Referring to FIG. 1, a schematic view of the structure of a prior art white light emitting device is illustrated. In FIG. 1, the white light emitting device includes a substrate 11, a PN light emitting junction 12 disposed on the substrate 11 for emitting a light source 13 of a wavelength, a phosphor 14 added during the packaging process for absorbing the light source 13 and transfer into another light source 15 of another wavelength. A white light source is produced by mixing the light sources 13, 15. FIG. 1 illustrates a mixed light emitting diode as disclosed in U.S. Pat. No. 5,998.925, and the mixed light diode is produced by packaging a gallium nitride (GaN) chip and a yttrium aluminum garnet (YAG) together, so that the blue light emitted from the GaN chip and the YAG phosphor absorbs a portion of the blue light to generate a yellow light source, and further produces a white light source when the yellow light source is mixed by another portion of the blue light. Therefore, the white light spectrum so obtained mainly contains a blue spectrum and a yellow spectrum, and thus it stills has the drawback of an unsaturated chromaticity.

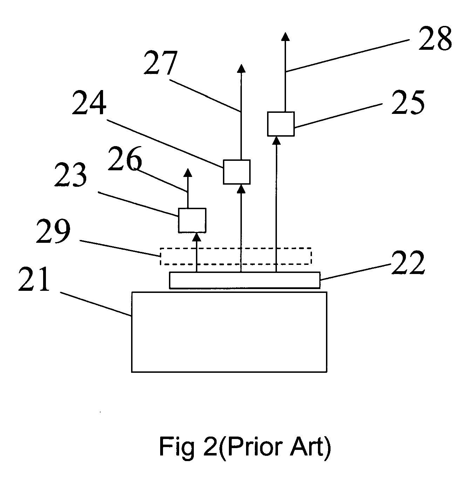

Referring to FIG. 2, a schematic view of the structure of another prior art white light emitting device disclosed in U.S. Pat. No. 6,084,250 is illustrated. In FIG. 2, the white light emitting device includes a substrate 21, an ultraviolet LED 22 formed on the substrate 21, three kinds of phosphors 23, 24, 25 added during the packaging process for absorbing an ultraviolet light 29 and then emitting a red light source 26, a green light source 27 and a blue light source 28 separately. The three light sources are mixed to produce a white light source, and thus the white light spectrum may have three primary color RGB spectra, but the chromaticity still has the drawback of the spectra hole when compared with a real white light.

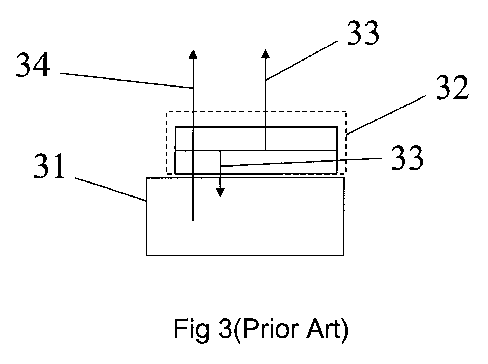

Referring to FIG. 3, a schematic view of the structure of a further prior art white light emitting device as disclosed in U.S. Pat. No. 6,337,536 is illustrated. In FIG. 3, the white light emitting device includes a substrate 31 made of zinc selenide (ZnSe), and blue light emitting diode capable of emitting a blue light source formed on the substrate 31 to produce a multilayer structure of ZnSe and Zn₁₋ₓCdₓSe. After the ZnSe substrate 31 absorbs a portion of the blue light emitted from the LED 32, a yellow light source 34 is generated, the two light sources are mixed to obtain a white light source. However, it is not easy to adjust such white light source to produce a white light emitting diode with an appropriate color temperature since phosphors are not used for adjusting the strength of the produced light source, and light emitting efficiency of such product is lower than that of the general LED products, and the lifetime of such product also requires further improvements.

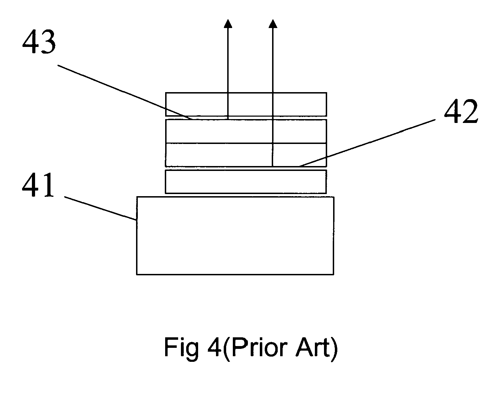

Referring to FIG. 4, a schematic view of another further prior art white light emitting device as disclosed in R.O.C. Publication No. 546852 is illustrated. In FIG. 4, the white light emitting device includes a substrate 41, a first light emitting layer 42 and a second light emitting layer 43, both layers being formed on the substrate 41, such that it only requires a tunneling barrier layer formed between two light emitting layers 42, 43 under the fixed wavelengths of the two main peaks. Therefore, the width of the tunneling barrier layer can be adjusted to change the tunneling probability of electric carriers through the tunneling layer so as to change the distribution of electric carriers that take part in the optoelectronic power conversion in the two light emitting areas. As a result, the relative light emitting strength of the two main peaks can be changed, and thus the ranges of the first wavelength emitted from the first light emitting layer and the second wavelength emitted from the second light emitting layer are mixed to allow the single chip to emit a mixed light (or a white light) with a specific chromaticity. The color of the mixed lights can be changed by changing the width of the tunneling barrier layer, if needed. However, forming a tunneling barrier layer between the two light emitting layers increases the ambient voltage of the device, and thus becoming a drawback to the power-saving design.

Therefore, developing a novel light emitting device to overcome the foregoing shortcomings of the prior arts is an important topic for manufactures and users and demand immediate attentions and feasible solutions. The inventor of the present invention based on years of experience on related research and development of the light emitting component related industry to invent a light emitting device and a method of synthesizing its light source to overcome the foregoing shortcomings.

### SUMMARY OF THE INVENTION

Therefore, it is a primary objective of the present invention to provide a light emitting device that uses a light emitting diode (LED) to simultaneously emit two light sources of different wavelengths in combination with at least one specific fluorescent material to absorb one of the foregoing two light sources of different wavelengths and then generate a third light source of another different wavelength to form a white light spectrum with a wide wavelength by combining the two light sources of different wavelengths.

Another objective of the present invention is to disclose a light emitting device that uses a light emitting diode (LED) to simultaneously emit two light sources of different wavelengths in combination with two selected fluorescent materials to absorb the foregoing two light sources and then generate the light sources of another two different wavelengths to form a white light source with a wide wavelength spectrum by combining the light sources with the two different wavelengths.

A further objective of the present invention is to disclose a light emitting device that that uses a light emitting diode (LED) to simultaneously emit a visible light source of a wavelength and an ultraviolet light source of another wavelength in combination with two selected fluorescent materials to absorb the wavelength of the foregoing ultraviolet light source to form a white light source with a wide wavelength spectrum by mixing the wavelengths of the visible light sources emitted from the light emitting diode.

Another further objective of the present invention is to disclose a light emitting device that uses a light emitting diode (LED) to simultaneously emit two visible light sources and an ultraviolet light source in combination with a selected fluorescent material to absorb the wavelength of the foregoing ultraviolet light source to form a light source of another wavelength, such that a white light with a wide wavelength spectrum can be produced by mixing the two visible wavelengths emitted from the light emitting diode.

Another object of the present invention is to disclose a light emitting device that uses a light emitting diode (LED) to simultaneously emit a visible light source and an ultraviolet light source in combination with three selected fluorescent materials to absorb the wavelength of the foregoing ultraviolet light source and respectively emit the light sources of three different wavelengths to form a white light with a wide wavelength spectrum by mixing the wavelengths of the visible light source emitted from the light emitting diode.

### BRIEF DESCRIPTION OF THE DRAWINGS

FIG. 1 is a schematic view of the structure of a prior art white light emitting device;
FIG. 2 is a schematic view of the structure of another prior art white light emitting device;
FIG. 3 is a schematic view of the structure of a further prior art white light emitting device;
FIG. 4 is a schematic view of the structure of another further prior art white light emitting device; and
FIG. 5 is a schematic view of the structure of a white light emitting device in accordance with the present invention.

### DETAILED DESCRIPTION OF THE PREFERRED EMBODIMENTS

To make it easier for our examiner to understand the objective of the invention, its innovative features and performance, a detailed description and technical characteristics of the present invention are described together with the drawings as follows.

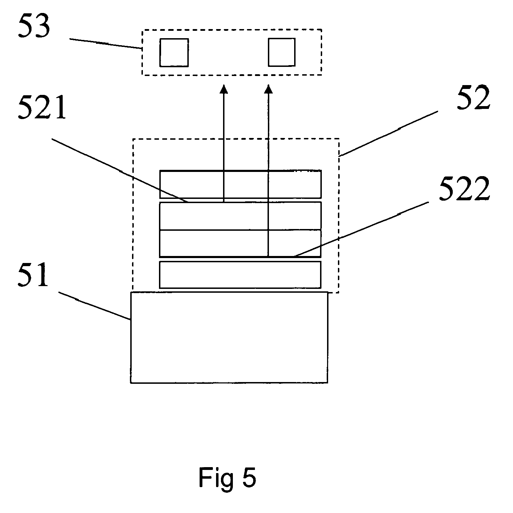

Referring to FIG. 5, a light emitting device comprises a substrate 51 and a light emitting diode 52. The light emitting diode 52 includes two light emitting layers 521, 522 usually made by stacking gallium nitride semiconductors with each other. The light emitting layer 521 can emit a light source with a wavelength smaller than or equal to 430nm or a light source with a wavelength greater than or equal to 470nm. The other light emitting layer 522 corresponding to the light emitting layer 521 emits a wavelength ranging from 430nm to 470nm. In FIG. 5, the light emitting device further comprises at least one phosphor 33 selected from the collection of Yttrium Oxide (Y₂O₃:Eu,Gd,Bi), Yttrium Oxide Sulfide (Y₂O₂S: Eu,Gd,Bi), ZnS:Cu,Al, Ca2MgSi₂O₇:Cl, BaMgAl₁₀O₁₇:Eu, (Sr,Ca,BaMg)₁₀(PO₄)₆Cl₂:Eu, Sr₅(PO₄)₃Cl:Eu²⁺, SrGa₂S₄:Eu. SrAl₂O₄:Eu²⁺, Ca(Eu₁₋ₓLaₓ)₄Si₃O₁₃, GdVO4:Eu³⁺,Bi³⁺, YVO4:Eu³⁺, CaTiO3:Pr³⁺, Bi³⁺, Sr₂P₂O₇:Eu,Mn, (Sr_{1-x-y-z}BaₓCa_{y}Eu_{z})₂SiO₄, Sulfides:Eu(AES:Eu²⁺), CaSrS:Br, Mg₆As₂O₁₁:Mn, MgO-MgF₂-GeO₂:Mn, Ca₈Mg(SiO₄)₄Cl₂:Eu,Mn, CaAl₂O₄:Eu,Nd and Ni-trido-silicates:Eu(AE₂Si₅N₈: Eu²⁺).

The phosphor 53 as shown in FIG. 5 receives the light emitted from a light emitting layer 521 according to the wavelength smaller than or equal to 430nm of the light emitted from the light emitting layer 521, and generates another light source with a wavelength larger than or equal to 470nm such that a white light with a wide wavelength spectrum can be produced by mixing the light source emitted from the light emitting layers 521, 522 and the light source produced by the phosphors 53.

The foregoing other light emitting junction 522 emits a wavelength ranging from 505nm to 580nm or from 580nm to 680nm corresponding to the light emitting layer 521.

Further, the foregoing white light with a wide wavelength spectrum has a wavelength selected from the collection of 430-470nm, 470nm-505nm, 505nm∼580nm and 580nm-680nm, or the collection of 470nm-505nm, 505nm∼580nm and 580nm-680nm, or the collection of 430-470nm, 470nm∼505nm and 580nm∼680nm.

While the invention has been described by way of example and in terms of a preferred embodiment, it is to be understood that the invention is not limited thereto. To the contrary, it is intended to cover various modifications and similar arrangements and procedures, and the scope of the appended claims therefore should be accorded the broadest interpretation so as to encompass all such modifications and similar arrangements and procedures.

In summation of the description above, the present invention is novel and useful and definite enhances the performance over the conventional structure and further complies with the patent application requirements and is submitted to the Patent and Trademark Office for review and granting of the commensurate patent rights.

## Claims

1. A light emitting device, comprising:
a light emitting diode, having at least two light emitting layers that emit a first light source with a first wavelength and a second light source of a second wavelength respectively; and
at least one phosphor, absorbing lights from said first light source and
transferring to emit a third wavelength as a third light source .

2. The light emitting device of claim 1, wherein said light emitting diode is made by GaN-based compound semiconductors.

3. The light emitting device of claim 1, wherein said first light source emits a wavelength ≦ 430nm for said first wavelength emitted from said first light source.

4. The light emitting device of claim 1, wherein said first light source emits a wavelength ≧ 470nm for said first wavelength emitted from said first light source.

5. The light emitting device of claim 1, wherein said second light source emits a wavelength ranging from 430nm to 470nm for said second wavelength emitted from said second light source.

6. The light emitting device of claim 1, wherein said second light source emits a wavelength ranging from 505nm to 580nm for said second wavelength emitted from said second light source.

7. The light emitting device of claim 1, wherein said second light source emits a wavelength ranging from 580nm to 680nm for said second wavelength emitted from said second light source.

8. The light emitting device of claim 1, wherein said first, second and third light sources are mixed to produce a white light with a wide wavelength spectrum.

9. The light emitting device of claim 1, wherein said phosphor comprises Yttrium Oxide (Y₂O₃:Eu,Gd,Bi), Yttrium Oxide Sulfide (Y₂O₂S: Eu,Gd,Bi), ZnS:Cu,Al, Ca2MgSi₂O₇:Cl, BaMgAl₁₀O₁₇:Eu, (Sr,Ca,BaMg)₁₀(PO₄)₆Cl₂:Eu, Sr₅(PO₄)₃Cl:Eu²⁺, SrGa₂S₄:Eu, SrAl₂O₄:Eu²⁺, Ca(Eu₁₋ₓLaₓ)₄Si₃O₁₃, GdVO4:Eu³⁺,Bi³⁺, YVO4:Eu³⁺, CaTiO3:Pr³⁺, Bi³⁺, Sr₂P₂O₇:Eu,Mn, (Sr_{1-x-y-z}BaₓCa_{y}Eu_{z})₂SiO₄, Sulfides:Eu(AES:Eu²⁺), CaSrS:Br, Mg₆As₂O₁₁:Mn, MgO·MgF₂·GeO₂:Mn, Ca₈Mg(SiO₄)₄Cl₂:Eu,Mn, CaAl₂O₄:Eu,Nd and Nitrido-silicates:Eu(AE₂Si₅N₈:Eu²⁺).

10. The light emitting device of claim 8, wherein said wide wavelength spectrum is comprised of different wavelength ranges selected from 430-470nm, 470nm-505nm, 505nm∼580nm and 580nm∼680nm.

11. The light emitting device of claim 8, wherein said wide wavelength spectrum is comprised of different wavelength ranges selected from 470nm-505nm, 505nm∼580nm and 580nm∼680nm.

12. The light emitting device of claim 8, wherein said wide wavelength spectrum is comprised of different wavelength ranges selected from 430-470nm, 470nm∼505nm and 580nm~680nm.
